# EUROPÄISCHE PATENTSCHRIFT

(11) **EP 2 059 822 B1**
(45) Veröffentlichungstag und Bekanntmachung des Hinweises auf die Patenterteilung: **01.11.2017**
(21) Anmeldenummer: 07786295.1
(22) Anmeldetag: 24.07.2007
(51) Int. Cl.: G01R 13/02, H04B 17/00

(54) **VORRICHTUNG UND VERFAHREN FÜR ANALYSE VON SIGNALVERLÄUFEN UNTER VERWENDUNG VON MASKEN**
DEVICE AND METHOD FOR ANALYZING SIGNAL WAVEFORMS USING MASKS
DISPOSITIF ET PROCÉDÉ D'ANALYSE DE LA VARIATION D'UN SIGNAL À L'AIDE DE MASQUES

(30) Priorität: 06.09.2006 DE 102006041824
(43) Veröffentlichungstag der Anmeldung: 20.05.2009
(73) Patentinhaber: Rohde & Schwarz GmbH & Co. KG, 81671 München (DE)
(72) Erfinder: KUHWALD, Thomas, 85570 Markt Schwaben (DE)
(74) Vertreter: Körfer, Thomas
(86) Internationale Anmeldenummer: PCT/EP2007/006569
(87) Internationale Veröffentlichungsnummer: WO 2008/028537

(56) Entgegenhaltungen:
- EP-A- 1 094 320
- JP-A- 2 116 757
- JP-A- 5 099 965
- US-B1- 6 785 540

## Beschreibung

Die vorliegende Erfindung bezieht sich auf die Analyse von Signalverläufen unter Verwendung von Masken.

Werden unter Verwendung von z.B. einem Oszilloskop Signalverläufe (Kurvenverläufe) von seriellen Datenströmen analysiert, so ist häufig eine Überprüfung des Signalverlaufs gegenüber vorgegebenen Maskenbereichen notwendig. Dabei darf der Signalverlauf den Maskenverlauf bzw. die Maske nicht berühren beziehungsweise nicht schneiden oder, im Falle von Toleranzschläuchen, den Maskenbereich nicht verlassen. Typischerweise sind solche Überprüfungen im Rahmen von Compliance-Tests von seriellen Schnittstellen und Datenübertragungssystemen vorgeschrieben.

Die Maskenüberprüfung wird typischerweise auf der Basis der Bildpunkte, die in einem Bildspeicher (Display-Speicher) eingespeichert sind, durchgeführt. Bei den Bildpunkten kann es sich um Signalbildpunkte handeln, die durch ein Oszilloskop erfasst, in Bildpunkte umgesetzt und im Bildspeicher gespeichert werden, wie es beispielsweise in EP 677 746 A2 beschrieben ist. Setzt sich der Signalverlauf beispielsweise aus Linien zusammen, so ist eine derartige Maskenüberprüfung jedoch aufwendig, da jeder Signalbildpunkt einzeln gesetzt und überprüft werden muss, wie beispielsweise in JP 2 116757 offenbart ist. Weiterhin entsteht im Falle einer direkten Überprüfung ein großer Speicherbedarf für die Ablage der Masken in einem Bildspeicher.

Es die Aufgabe der Erfindung, eine effiziente Vorrichtung und ein effizientes Verfahren zum Analysieren eines Signalverlaufs unter Verwendung einer Maske zu schaffen.

Diese Aufgabe wird durch die Merkmale der unabhängigen Ansprüche 1 bzw. 11 gelöst.

Der Erfindung liegt die Erkenntnis zu Grunde, dass eine effiziente Analyse eines Signalverlaufs bezüglich einer Maske auf der Basis von Adressen der in einem Bildspeicher gespeicherten Signalbildpunkte durchgeführt werden kann. Dabei wird ausgenutzt, dass der zuvor erfasste Signalverlauf in einem Bildspeicher vorliegt, wobei einem Signalbildpunkt eine Bildadresse (zum Beispiel eine Pixel-Adresse umfassend eine Zeilen- und/oder eine Spaltennummer) zugeordnet ist.

Die Maske kann ebenfalls durch eine Mehrzahl von Maskenbildpunkten grafisch dargestellt werden, wobei die Maskenbildpunkte Bildzeilen oder Bildspalten zugeordnet sind. Bei einer derartigen Zuordnung ist jeder Maskenbildpunkt durch eine Bildadresse (beispielsweise eine Zeilennummer eine Spaltennummer) lokalisierbar. Erfindungsgemäß wird die Maskenüberprüfung jedoch auf der Basis der Bildadressen der Maskenbildpunkte und der Bildadressen der Signalpunkte durchgeführt. Denn es kann bereits auf der Basis eines Adressenvergleichs festgestellt werden, ob ein Signalbildpunkt beispielsweise oberhalb oder unterhalb eines in derselben Bildzeile und/oder Bildspalte angeordneten Maskenbildpunktes angeordnet ist, wodurch eine Maskenverletzung schnell und effizient festgestellt werden kann.

Die vorliegende Erfindung schafft eine Analysevorrichtung zum Analysieren eines Signalverlaufs unter Verwendung einer Maske, wobei der Signalverlauf durch ein Signalbild und die Maske durch ein Maskenbild grafisch repräsentierbar beziehungsweise darstellbar (z.B. als eine Folge von Spannungs- beziehungsweise Stromwerten) sind.

Die Analysevorrichtung umfasst eine Speichereinrichtung zum Bereitstellen einer Signalbildadresse eines Signalbildpunktes des Signalbildes und zum Bereitstellen einer Maskenbildadresse eines Maskenbildpunktes des Maskenbildes. Ferner ist eine Vergleichseinrichtung zum Vergleichen der Signalbildadresse und der Maskenbildadresse vorgesehen, wobei die Vergleichseinrichtung gemäß einem Aspekt eine Anordnung des Signalbildpunktes bezüglich des Maskenbildpunktes bestimmen kann.

Gemäß einem Aspekt kann die Speichereinrichtung einen Bildspeicher zum Speichern des Signalbildpunktes und einen Maskenspeicher zum Speichern der Maskenbildadresse des Maskenbildpunktes umfassen. Der Bildspeicher und der Maskenspeicher weisen bevorzugt unterschiedliche Speicherbereiche auf.

Der Maskenspeicher kann beispielsweise ein flüchtiger oder ein nicht-flüchtiger Speicher sein, in dem eine oder mehrere Maskenbildadressen z.B. dauerhaft speicherbar sind. Die Maskenbildadresse kann eine Bildzeilennummer und/oder eine Bildspaltennummer aufweisen, die einer Bildzeile beziehungsweise einer Bildspalte zugeordnet sind. Die Maskenbildadresse definiert beispielsweise einen Maskenbildbereich, oberhalb oder unterhalb dessen ein Toleranzbereich festgelegt wird, innerhalb dessen die Anordnung des Signalbildpunktes zulässig (keine Maskenverletzung) oder nicht zulässig (Maskenverletzung) ist. Die Signalbildadresse des Signalbildpunktes kann dabei in Form einer Zeilennummer und/oder einer Spaltennummer bereitgestellt oder gespeichert werden.

Die Analysevorrichtung umfasst ferner eine Vergleichseinrichtung zum Vergleichen der Signalpunktadresse mit der Maskenbildadresse, um beispielsweise eine relative Anordnung des Signalbildpunktes bezüglich des Maskenbildpunktes zu bestimmen.

Bei der Anordnung des Signalbildpunktes bezüglich des Maskenbildpunktes kann es sich um eine Angabe handeln, ob der Signalbildpunkt oberhalb oder unterhalb des Maskenbildpunktes angeordnet ist oder ob der Signalbildpunkt und der Maskenbildpunkt zusammenfallen. Die Vergleichseinrichtung kann auf der Basis der Anordnung des Signalbildpunktes bezüglich des Maskenbildpunktes feststellen, ob der Signalbildpunkt innerhalb oder außerhalb eines durch den Maskenbildpunkt beziehungsweise durch die Maske vorgegebenen Maskenbereichs angeordnet ist. Gemäß einem Aspekt kann die Vergleichseinrichtung ein Vergleichssignal ausgeben, das die Anordnung des Signalbildpunktes bezüglich des Maskenbildpunktes und bezüglich des Maskenbereichs anzeigt.

Gemäß einem Aspekt kann die Speichereinrichtung ferner eine weitere Maskenbildadresse, die einem weiteren Maskenbildpunkt zugeordnet ist, bereitstellen. Durch den Maskenbildpunkt und durch den weiteren Maskenbildpunkt kann ein Maskenbildpunktpaar bereitgestellt werden, das einen Toleranzbereich (z.B. einen Toleranzschlauch) festlegt, innerhalb oder außerhalb dessen eine Anordnung des Signalbildpunktes zulässig oder nicht zulässig ist. Die Vergleichseinrichtung kann die Signalbildadresse des Signalbildpunktes mit der Maskenbildadresse und mit der weiteren Maskenbildadresse vergleichen, um die Anordnung des Signalbildpunktes bezüglich des Maskenbildpunktes und des weiteren Maskenbildpunktes zu bestimmen. Die Analysevorrichtung kann ferner auf der Basis des Vergleichs feststellen, ob der Signalbildpunkt innerhalb oder außerhalb des durch das Maskenbildpunktpaar vorgegebenen Maskenbereichs angeordnet ist.

Beispielsweise sind der Signalbildpunkt, der Maskenbildpunkt und der weitere Maskenbildpunkt innerhalb derselben Bildzeile oder innerhalb derselben Bildspalte angeordnet. Das Maskenbildpunktpaar legt somit einen Maskenbereich innerhalb dieser Bildzeile oder dieser Bildspalte fest. Durch die Maskenbildpunkte wird die Ausdehnung der Maske innerhalb der betreffenden Bildzeile oder Bildspalte festgelegt.

Die Vergleichseinrichtung kann auf der Basis eines oder mehrerer der folgenden Relationsvergleiche feststellen, ob eine Maskenverletzung vorliegt oder nicht. Eine Maskenverletzung liegt beispielsweise nicht vor, falls
mₛₜₐᵣₜ < yₛₜₐᵣₜ und m_{end} < yₛₜₐᵣₜ und/oder
mₛₜₐᵣₜ > y_{end} und m_{end} > y_{end} und/oder
mₛₜₐᵣₜ ≤ yₛₜₐᵣₜ und m_{end} ≥ y_{end}.

Dabei bezeichnen mₛₜₐᵣₜ eine Maskenbildadresse eines Maskenbildpunktes (z.B. einen Anfangspunkt eines Maskenbereichs), m_{end} eine weitere Maskenbildadresse eines weiteren Maskenbildpunktes (z.B. einen Endpunkt des Maskenbereichs), yₛₜₐᵣₜ eine Signalbildadresse eines Signalbildpunktes (z.B. einen Anfangspunkt eines Signalbereichs) und y_{end} eine weitere Signalbildadresse eines weiteren Signalbildpunktes (z.B. einen Endpunkt des Signalbereichs).

Ferner kann die Speichereinrichtung eine Mehrzahl von Maskenbildadresspaaren bereitstellen. Ein jeweiliges Maskenbildadresspaar ist bevorzugt jeweils einer Bildspalte oder einer Bildzeile zugeordnet und definiert beispielsweise einen Bildspaltenbereich oder einen Bildzeilenbereich, innerhalb dessen sich die Maske erstreckt. Die Vergleichseinrichtung kann eine oder mehrere von Signalbildadressen mit den Maskenbildadresspaaren vergleichen, um festzustellen, ob der Signalverlauf innerhalb oder außerhalb eines Toleranzbereiches angeordnet ist.

Gemäß einem weiteren Aspekt umfasst die Analysevorrichtung eine Erfassungseinrichtung zum Erfassen des Signalverlaufs (beispielsweise durch eine Messung) und eine Berechungseinrichtung zum Berechnen der Signalbildadressen aus dem erfassten Signalverlauf. Die Berechnungseinrichtung bildet beispielsweise die gemessenen Signalverlaufwerte auf einen Bildraster ab, wobei die jeweiligen Bildrasteradressen als Signalbildadressen bereitgestellt und/oder gespeichert werden können.

Die Erfindung schafft ferner ein Analyseverfahren zum Analysieren eines Signalverlaufs unter Verwendung einer Maske, wobei der Signalverlauf durch ein Signalbild und wobei die Maske durch ein Maskenbild grafisch repräsentierbar sind, wobei eine Maskenbildadresse eines Maskenbildpunktes des Maskenbildes und eine Signalbildadresse eines Signalbildpunktes des Signalbildes bereitgestellt werden und wobei die Signalbildadresse und die Maskenbildadresse verglichen werden, um eine Anordnung des Signalbildpunktes bezüglich des Maskenbildpunktes zu bestimmen. Ferner können der Signalbildpunkt in einem Bildspeicher und die Maskenbildadresse in einem Maskenspeicher bereitgestellt werden. Gemäß einem Aspekt wird die Signalbildadresse auf der Basis des Signalbildpunktes bereitgestellt.

Gemäß einem Aspekt wird auf der Basis der Anordnung des Signalbildpunktes bezüglich des Maskenbildpunktes festgestellt, ob der Signalbildpunkt innerhalb oder außerhalb eines durch die Maske vorgegebenen Maskenbereichs angeordnet ist.

Gemäß einem Aspekt wird eine weitere Maskenbildadresse eines weiteren Maskenbildpunktes bereitgestellt, wobei die Signalbildadresse mit der Maskenbildadresse und mit der weiteren Maskenbildadresse verglichen wird, um die Anordnung des Signalbildpunktes bezüglich des Maskenbildpunktes und bezüglich des weiteren Maskenbildpunktes zu bestimmen.

Gemäß einem Aspekt wird auf der Basis der Anordnung des Signalbildpunktes bezüglich des Maskenbildpunktes und des weiteren Maskenbildpunktes festgestellt, ob der Signalbildpunkt innerhalb oder außerhalb eines durch den Maskenbildpunkt und durch den weiteren Maskenbildpunkt festgelegten Toleranzbereichs angeordnet ist.

Gemäß einem Aspekt wird festgestellt, dass keine Maskenverletzung vorliegt, falls eine oder mehrere der folgenden Bedingungen erfüllt ist/sind:
mₛₜₐᵣₜ < yₛₜₐᵣₜ und m_{end} < yₛₜₐᵣₜ oder
mₛₜₐᵣₜ > y_{end} und m_{end} > y_{end} oder
mₛₜₐᵣₜ ≤ yₛₜₐᵣₜ und m_{end} ≥ y_{end}.

Dabei ist mₛₜₐᵣₜ eine Maskenbildadresse eines Maskenbildpunktes, m_{end} ist eine weitere Maskenbildadresse eines weiteren Maskenbildpunktes, yₛₜₐᵣₜ ist eine Signalbildadresse eines Signalbildpunktes und y_{end} ist eine weitere Signalbildadresse eines weiteren Signalbildpunktes.

Gemäß einem Aspekt werden eine Mehrzahl von Maskenbildadresspaaren, wobei ein Maskenbildadresspaar eine Maskenbildadresse und eine weitere Maskenbildadresse umfasst und einen Maskenbereich innerhalb einer Bildspalte oder einer Bildzeile festlegt, und eine Mehrzahl von Signalbildadressen, wobei eine Signalbildadresse einem Signalbildpunkt in einer Bildspalte oder in einer Bildzeile zugeordnet ist, bereitgestellt. Ferner wird jeweils eine Signalbildadresse, die einem einer Bildzeile oder Bildspalte zugeordneten Signalbildpunkt zugeordnet ist, mit einem dieser Bildspalte oder dieser Bildzeile zugeordneten Maskenbildadresspaar verglichen, um eine Anordnung des Signalbildpunktes bezüglich des Maskenbereichs zu bestimmen.

Gemäß einem weiteren Aspekt wird der Signalverlauf erfasst, wobei die Signalbildadresse aus dem erfassten Signalverlauf berechnet wird.

Die vorliegende Erfindung schafft ferner ein Speichermedium und ein Computerprogramm zum Ausführen des erfindungsgemäßen Analyseverfahrens, wenn das Computerprogramm auf einem Computer abläuft. Gemäß einem weiteren Aspekt schafft die Erfindung ein Speichermedium und ein Computerprogrammprodukt mit einem auf einem Speichermedium, beispielsweise auf einer Diskette oder einer CD, gespeicherten Programmcode zur Ausführung des erfindungsgemäßen Analyseverfahrens.

Weitere Ausführungsbeispiele der Erfindung werden bezugnehmend auf die Zeichnung erläutert. Es zeigen:
- Fig. 1: ein Blockdiagramm einer Analysevorrichtung; und
- Fig. 2: ein Blockdiagramm einer Speichervorrichtung.

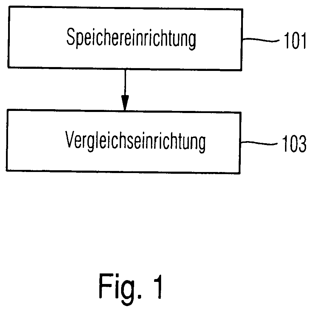

Fig. 1 zeigt ein Blockdiagramm einer Analysevorrichtung zum Analysieren eines Signalverlaufs unter Verwendung einer Maske. Die Analysevorrichtung umfasst eine Speichereinrichtung 101, die mit einer Vergleichseinrichtung 103 gekoppelt ist.

Die Speichereinrichtung 101 umfasst gemäß einem Aspekt einen Bildspeicher, in dem zur Maskenüberprüfung Bilddaten differenziell abgelegt werden können. Die Speichereinrichtung 101 kann ferner einen Maskenspeicher aufweisen, in dem beispielsweise Maskensegmente in Form von Maskenbildadressen speicherbar sind.

Die Bilddaten (z.B. das Signalbild oder der Signalverlauf) können beispielsweise als Linien dargestellt werden, wobei die Linien im Bildspeicher nicht explizit gezeichnet werden. Beispielsweise werden ein Startpunkt +1 und ein Endpunkt mit -1 markiert, wobei der Startpunkt und der Endpunkt jeweils durch eine Signalbildadresse und durch eine weitere Signalbildadresse repräsentiert werden können. Da im Bildspeicher auch mehrere Signalverläufe übereinander mittels einer Häufigkeitsverteilung dargestellt werden können, kann der Startpunkt jeweils ausgelesen und beispielsweise um 1 inkrementiert werden, wobei der Endpunkt dekrementiert wird. Das eigentliche Ziehen der Linien kann anschließend beim Auslesen der Pixelspalten des Bildspeichers erfolgen, indem ein Integral über die Pixelspalten gebildet wird. Dieses Verfahren liefert eine effiziente Grundlage für die Maskenüberprüfung.

Aufgrund der erfindungsgemäßen Form der Bilddarstellung sind für die Maskenüberprüfungen beispielsweise nur die Start- beziehungsweise die Endpunkte der Linien einer Pixelspalte bekannt, wodurch eine Reduktion der Speichergröße erzielt wird. Basierend auf diesen Punkten ist eine einfache Maskenüberprüfung möglich.

Die Maskensegmente, beispielsweise durch Maskenbildadressen festgelegte Maskenbereiche, gegen die eine Überprüfung durchzuführen ist, können ebenfalls durch ihre Start- beziehungsweise Endpunkte pro Pixelspalte (zum Beispiel Maskenbildadresse eines Maskenbildpunktes und eine weitere Maskenbildadresse eines weiteren Maskenbildpunktes) vorgegeben werden. Diese Punkte können im Speicher hinterlegt werden, der spaltenorganisiert sein kann und dieselbe Anzahl von Spalten wie die Bildspeicher aufweisen kann. Pro Spalte kann z.B. jeweils der Start- und Endpunkt der Maske innerhalb der zugeordneten Pixelspalte hinterlegt werden.

Gemäß einem weiteren Aspekt können mehrere Masken verwendet werden, so dass ein Signalverlauf oder mehrere Signalverläufe gegen eine Mehrzahl von Masken überprüft werden können.

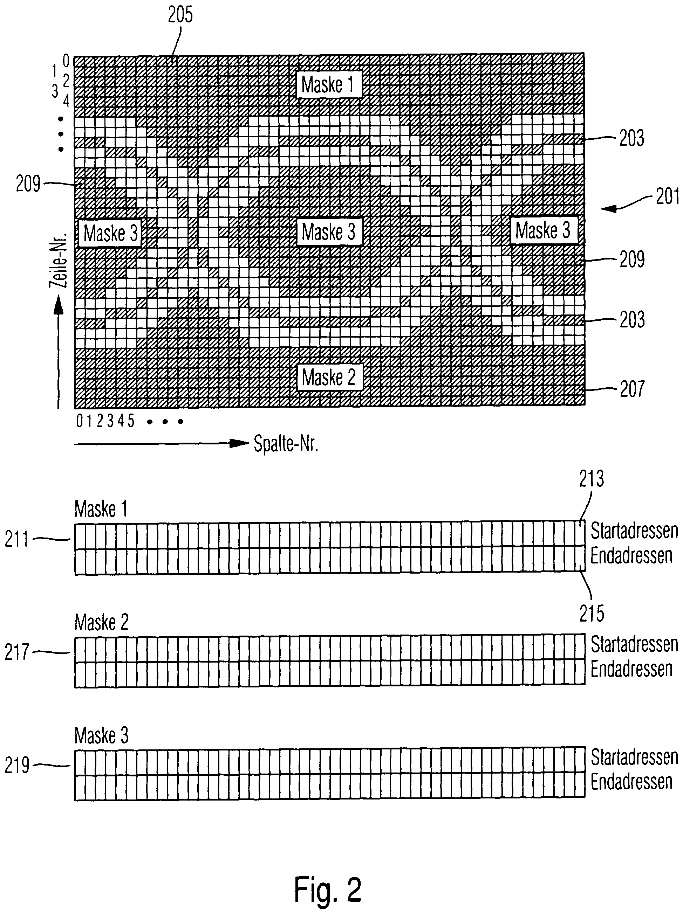

Fig. 2 zeigt eine Speichereinrichtung mit einem Bildspeicher 201, der in Form von Zeilen und Spalten organisiert ist. Die Zeilen und die Spalten sind jeweils durch eine Zeilennummer und eine Spaltennummer adressierbar, wobei beispielsweise die Spaltennummern in Richtung des in Fig. 2 dargestellten horizontalen Pfeiles inkrementiert werden. Die Zeilennummern werden beispielsweise in Richtung des in Fig. 2 dargestellten vertikalen Pfeiles dekrementiert. Im Bildspeicher 201 können beispielsweise die Signalbildpunkte eines Signalverlaufs 203 abgelegt werden, wobei jedem Signalbildpunkt eine Signalbildadresse umfassend beispielsweise eine Zeilennummer und eine Spaltennummer zugeordnet ist.

Gemäß einem Aspekt umfasst die Analysevorrichtung einen ersten Maskenspeicher 211, in dem jeweils paarweise Maskenbildadresspaare gespeichert sind, wobei jedes Maskenbildadresspaar eine Startadresse und eine Endadresse des jeweiligen in einer Spalte darstellbaren Maskenbereichs umfasst. Der Maskenspeicher 211 ist beispielsweise spaltenorganisiert und umfasst dieselbe Anzahl von Spalten wie der Bildspeicher 201. Dabei ist jeder Spalte des Bildspeichers 201 ein in einem Speicherbereich des Speichers 211 jeweils gespeichertes Maskenbildadresspaar zugeordnet. Die Startadressen (Anfangsadressen) sind beispielsweise in den Speicherbereichen 213 gespeichert. Die Endadressen sind beispielsweise in den Speicherbereichen 215 gespeichert.

Der Signalverlauf 203 kann bezüglich einer Mehrzahl von Masken analysiert werden, z.B. gegen eine erste Maske 205, gegen eine zweite Maske 207 oder gegen eine dritte Maske 209.

Falls der Signalverlauf 203 oder mehrere Signalverläufe 203 gegen eine Mehrzahl von Masken überprüft werden sollen, so kann die Analysevorrichtung ferner eine Mehrzahl von Maskenspeichern aufweisen, wobei in Fig. 2 exemplarisch ein zweiter Maskenspeicher 217 und ein dritter Maskenspeicher 219 dargestellt sind.

Der Maskenspeicher 217 kann beispielsweise die Startadressen und die Endadressen der Maskenbildpunkte der zweiten Maske 207 und der Speicher 219 kann beispielsweise die Startadressen und die Endadressen der Maskenbildpunkte der dritten Maske 209 speichern beziehungsweise bereitstellen. Die Maskenspeicher 217 und 219 sind bevorzugt identisch aufgebaut wie der Maskenspeicher 211.

Gemäß einem weiteren Aspekt kann die Analysevorrichtung genauso viele Maskenspeicher aufweisen, wie viele Masken angelegt werden sollen. Mittels eines Maskenspeichers kann beispielsweise eine beliebig geformte Maske über die gesamte Bildschirmbreite realisiert werden. Beliebig bedeutet in diesem Zusammenhang, dass pro Spalte z.B. nur ein Start- und ein Endpunkt vorlegen. Gemäß einem Aspekt wird der Signalverlauf (203) zunächst durch eine Erfassungseinrichtung auf der Basis einer Signalerfassung (z.B. Messung) erfasst und es werden dann auf der Basis des erfassten Signalverlaufes Bildpunkte berechnet, die aufgrund des aktuell erfassten Signalverlaufes gesetzt oder als Linie verbunden werden können.

Nach der Berechnung der Bildpunkte kann die Maskenüberprüfung wie folgt realisiert werden:
In einem Darstellungsmodus können beispielsweise mit Hilfe eines Algorithmus die jeweiligen Start- und Endpunkte einer Linie erfasst und mit yₛₜₐᵣₜ beziehungsweise y_{end} bereitgestellt werden. Beispielsweise aus dem ersten Maskenspeicher 211 werden der jeweilige Start- und Endpunkt der Maske ausgelesen und bereitgestellt, wobei der Start- und der Endpunkt mit mₛₜₐᵣₜ bzw. m_{end} bezeichnet sind. Erfindungsgemäß kann beispielsweise eine Verletzung der Maske auf der Basis von Relationsvergleichen überprüft werden. Wird festgestellt, dass
mₛₜₐᵣₜ < yₛₜₐᵣₜ und m_{end} < yₛₜₐᵣₜ
und/oder dass
mₛₜₐᵣₜ > y_{end} und m_{end} > y_{end}
zutrifft, so liegt keine Verletzung der Maske vor, weil der Signalverlauf oberhalb bzw. unterhalb der Maske angeordnet ist. Falls keine der obigen Bedingungen erfüllt ist, liegt eine Verletzung der Maske vor.

Soll beispielsweise eine Maske als ein Toleranzschlauch verwendet werden, so können beispielsweise die folgenden Relationen überprüft werden:
mₛₜₐᵣₜ ≤ yₛₜₐᵣₜ und m_{end} ≥ y_{end}.

Sind diese Relationen erfüllt, so liegt keine Verletzung der Maske vor, andernfalls wird der Toleranzschlauch verletzt.

Diese Überprüfungen können gemäß einem Aspekt für alle Maskenbereiche separat durchgeführt werden. Darüber hinaus kann zusätzlich die Anzahl der Bildpunkte auf der Basis von z.B. Differenzbildungen bestimmt werden, welche die Maske verletzen. Die Differenzbildungen können beispielsweise durch die Vergleichseinrichtung durchgeführt werden.

Die Erfindung ist nicht auf die dargestellten Ausführungsbeispiele beschränkt. Beispielsweise kann die beschriebene Maskierung nicht nur bei Signalen im Zeitbereich, beispielsweise eines Oszilloskops, verwendet werden, sondern auch für Signale im Frequenzbereich, beispielsweise eines Spektrumanalysators oder eines Netzwerkanalysators. Alle beschriebenen und/oder gezeichneten Merkmale sind im Rahmen der Erfindung beliebig miteinander kombinierbar.

## Patentansprüche

1. Analysevorrichtung zum Analysieren eines Signalverlaufs unter Verwendung einer Maske, wobei der Signalverlauf durch ein Signalbild und wobei die Maske durch ein Maskenbild grafisch repräsentierbar sind, mit:
einer Speichereinrichtung (101) zum Bereitstellen einer Signalbildadresse eines Signalbildpunktes des Signalbildes und zum Bereitstellen einer Maskenbildadresse eines Maskenbildpunktes des Maskenbildes; und einer Vergleichseinrichtung (103);
wobei mittels mehrerer Maskenspeicher mehrere beliebig geformte Masken über eine gesamte Bildschirmbreite realisierbar sind,
**dadurch gekennzeichnet,**
**dass** die Vergleichseinrichtung (103) zum Vergleichen der Signalbildadresse mit der Maskenbildadresse konfiguriert ist, um eine Anordnung des Signalbildpunktes bezüglich des Maskenbildpunktes zu bestimmen.

2. Analysevorrichtung gemäß Anspruch 1,
wobei die Speichereinrichtung (101) einen
Bildspeicher (201) zum Speichern des Signalbildpunktes und einen Maskenspeicher (211, 217, 219) zum Speichern der Maskenbildadresse des Maskenbildpunktes umfasst.

3. Analysevorrichtung gemäß Anspruch 2,
wobei der Bildspeicher (201) ausgebildet ist, um die Signalbildadresse des Signalbildpunktes bereitzustellen.

4. Analysevorrichtung gemäß einem der Ansprüche 1 bis 3, wobei die Vergleichseinrichtung (103) ausgebildet ist, um auf der Basis der Anordnung des Signalbildpunktes bezüglich des Maskenbildpunktes festzustellen, ob der Signalbildpunkt innerhalb oder außerhalb eines durch die Maske vorgegebenen Maskenbereichs angeordnet ist.

5. Analysevorrichtung gemäß einem der Ansprüche 1 bis 4, wobei die Speichereinrichtung (101) ausgebildet ist, um eine weitere Maskenbildadresse eines weiteren Maskenbildpunktes bereitzustellen, und
wobei die Vergleichseinrichtung (103) ausgebildet ist, um die Signalbildadresse mit der Maskenbildadresse und mit der weiteren Maskenbildadresse zu vergleichen, um die Anordnung des Signalbildpunktes bezüglich des Maskenbildpunktes und bezüglich des weiteren Maskenbildpunktes zu bestimmen.

6. Analysevorrichtung gemäß Anspruch 5,
wobei der Signalbildpunkt, der Maskenbildpunkt und der weitere Maskenbildpunkt innerhalb derselben Bildzeile oder derselben Bildspalte angeordnet sind, und wobei der Maskenbildpunkt einen Anfang und wobei der weitere Maskenbildpunkt ein Ende eines innerhalb der Bildzeile oder der Bildspalte angeordneten Maskenbereichs festlegen.

7. Analysevorrichtung gemäß Anspruch 5 oder 6,
wobei die Vergleichseinrichtung (103) ferner ausgebildet ist, um auf der Basis der Anordnung des Signalbildpunktes bezüglich des Maskenbildpunktes und des weiteren Maskenbildpunktes festzustellen, ob der Signalbildpunkt innerhalb oder außerhalb eines durch den Maskenbildpunkt und den weiteren Maskenbildpunkt festgelegten Toleranzbereichs angeordnet ist.

8. Analysevorrichtung gemäß einem der Ansprüche 1 bis 7,
wobei die Vergleichseinrichtung (103) ausgebildet ist, um festzustellen, dass keine Maskenverletzung vorliegt, falls eines oder mehrere der folgenden Bedingungen erfüllt ist/sind:
mₛₜₐᵣₜ < yₛₜₐᵣₜ und m_{end <} yₑₜₐᵣₜ
oder
mₛₜₐᵣₜ > y_{end} und m_{end <} > y_{end}
oder
mₛₜₐᵣₜ ≤ yₛₜₐᵣₜ und m_{end} ≥ y_{end},
wobei mₛₜₐᵣₜ eine Maskenbildadresse eines Maskenbildpunktes ist, wobei m_{end} eine weitere Maskenbildadresse eines weiteren Maskenbildpunktes ist, wobei yₛₜₐᵣₜ eine Signalbildadresse eines Signalbildpunktes ist und wobei y_{end} eine weitere Signalbildadresse eines weiteren Signalbildpunktes ist.

9. Analysevorrichtung gemäß einem der Ansprüche 1 bis 8, wobei die Speichereinrichtung (101) ausgebildet ist, um eine Mehrzahl von Maskenbildadresspaaren bereitzustellen, wobei ein Maskenbildadresspaar eine Maskenbildadresse und eine weitere Maskenbildadresse umfasst und einen Maskenbereich innerhalb einer Bildspalte oder einer Bildzeile festlegt.

10. Analysevorrichtung gemäß einem der Ansprüche 1 bis 9, die ferner eine Erfassungseinrichtung zum Erfassen des Signalverlaufs und eine Berechnungseinrichtung zum Berechnen der Signalbildadresse aus dem erfassten Signalverlauf aufweist.

11. Analyseverfahren zum Analysieren eines Signalverlaufs unter Verwendung einer Maske, wobei der Signalverlauf durch ein Signalbild und wobei die Maske durch ein Maskenbild grafisch repräsentierbar sind, mit den Verfahrensschritten:
Bereitstellen einer Maskenbildadresse eines Maskenbildpunktes des Maskenbildes;
Bereitstellen einer Signalbildadresse eines Signalbildpunktes des Signalbildes; und
Vergleichen der Signalbildadresse und der Maskenbildadresse, um eine Anordnung des Signalbildpunktes bezüglich des Maskenbildpunktes zu bestimmen,
**dadurch gekennzeichnet,**
**dass** mittels mehrerer Maskenspeicher mehrere beliebig geformte Masken über eine gesamte Bildschirmbreite realisiert werden.

12. Analyseverfahren gemäß Anspruch 11, mit den zusätzlichen Verfahrensschritten:
Bereitstellen des Signalbildpunktes in einem Bildspeicher; und
Bereitstellen der Maskenbildadresse in einem Maskenspeicher.

13. Analyseverfahren gemäß Anspruch 12, mit den zusätzlichen Verfahrensschritten:
Bereitstellen der Signalbildadresse auf der Basis des Signalbildpunktes.

14. Analyseverfahren gemäß einem der Ansprüche 11 bis 13, mit den zusätzlichen Verfahrensschritten:
Feststellen auf der Basis der Anordnung des Signalbildpunktes bezüglich des Maskenbildpunktes, ob der Signalbildpunkt innerhalb oder außerhalb eines durch die Maske vorgegebenen Maskenbereichs angeordnet ist.

15. Analyseverfahren gemäß einem der Ansprüche 11 bis 14, mit den zusätzlichen Verfahrensschritten:
Bereitstellen einer weiteren Maskenbildadresse eines weiteren Maskenbildpunktes; und
Vergleichen der Signalbildadresse mit der Maskenbildadresse und mit der weiteren Maskenbildadresse, um die Anordnung des Signalbildpunktes bezüglich des Maskenbildpunktes und bezüglich des weiteren Maskenbildpunktes zu bestimmen.

16. Analyseverfahren gemäß Anspruch 15,
wobei der Signalbildpunkt, der Maskenbildpunkt und der weitere Maskenbildpunkt innerhalb derselben Bildzeile oder derselben Bildspalte angeordnet sind, und wobei der Maskenbildpunkt einen Anfang und wobei der weitere Maskenbildpunkt ein Ende eines innerhalb der Bildzeile oder der Bildspalte angeordneten Maskenbereichs festlegen.

17. Analyseverfahren gemäß Anspruch 15 oder 16, mit den zusätzlichen Verfahrensschritten:
Feststellen auf der Basis der Anordnung des Signalbildpunktes bezüglich des Maskenbildpunktes und des weiteren Maskenbildpunktes, ob der Signalbildpunkt innerhalb oder außerhalb eines durch den Maskenbildpunkt und durch den weiteren Maskenbildpunkt festgelegten Toleranzbereichs angeordnet ist.

18. Analyseverfahren gemäß einem der Ansprüche 11 bis 17, mit den zusätzlichen Verfahrensschritten:
Bereitstellen einer weiteren Signalbildadresse eines weiteren Signalbildpunktes; und
Vergleichen der Maskenbildadresse mit der Signalbildadresse und mit der weiteren Signalbildadresse, um die Anordnung des Signalbildpunktes und des weiteren Signalbildpunktes bezüglich des Maskenbildpunktes zu bestimmen.

19. Analyseverfahren gemäß einem der Ansprüche 11 bis 18, mit den zusätzlichen Verfahrensschritten:
Feststellen, dass keine Maskenverletzung vorliegt, falls eine oder mehrere der folgenden Bedingungen erfüllt sind:
mₛₜₐᵣₜ < yₛₜₐᵣₜ und m_{end} < yₛₜₐᵣₜ
oder
mₛₜₐᵣₜ > y_{end} und m_{end} > y_{end}
oder
mₛₜₐᵣₜ ≤ yₛₜₐᵣₜ und m_{end} ≥ y_{end,}
wobei mₛₜₐᵣₜ eine Maskenbildadresse eines Maskenbildpunktes ist, wobei m_{end <} eine weitere Maskenbildadresse eines weiteren Maskenbildpunktes ist, wobei yₛₜₐᵣₜ eine Signalbildadresse eines Signalbildpunktes ist und wobei y_{end} eine weitere Signalbildadresse eines weiteren Signalbildpunktes ist.

20. Analyseverfahren gemäß einem der Ansprüche 11 bis 19, mit den zusätzlichen Verfahrensschritten:
Bereitstellen einer Mehrzahl von Maskenbildadresspaaren,
wobei ein Maskenbildadresspaar eine Maskenbildadresse und eine weitere Maskenbildadresse umfasst und einen Maskenbereich innerhalb einer Bildspalte oder einer Bildzeile festlegt.

21. Analyseverfahren gemäß einem der Ansprüche 11 bis 20, mit:
Erfassen des Signalverlaufs; und
Berechnen der Signalbildadresse aus dem erfassten Signalverlauf.

22. Digitales Speichermedium mit elektronisch auslesbaren Steuersignalen, die so mit einem programmierbaren Computer oder digitalen Signalprozessor zusammenwirken können, dass das Verfahren nach einem der Ansprüche 11 bis 21 ausgeführt wird.

23. Computerprogramm-Produkt mit auf einem maschinenlesbaren Träger gespeicherten Programmcode-Mitteln, um alle Schritte gemäß einem der Ansprüche 11 bis 21 durchführen zu können, wenn das Programm auf einem Computer oder einem digitalen Signalprozessor ausgeführt wird.

24. Computerprogramm mit Programmcode-Mitteln, um alle Schritte gemäß einem der Ansprüche 11 bis 21 durchführen zu können, wenn das Programm auf einem Computer oder einem digitalen Signalprozessor ausgeführt wird.

## Claims

1. Analytical device for analysing a signal waveform using a mask, wherein the signal waveform can be represented graphically by a signal image and wherein the mask can be represented graphically by a mask image, with:
a buffer or storage means (101) for providing a signal image address of a signal image point of the signal image and for providing a mask image address of a mask image point of the mask image; and
a comparison means (103);
wherein a plurality of arbitrarily formed masks can be created over an entire image screen width by means of a plurality of mask buffers,
**characterised in that**
the comparison means (103) is configured to compare the signal image address with the mask image address in order to determine an arrangement of the signal image point with respect to the mask image point.

2. Analytical device according to claim 1,
wherein the buffer or storage means (101) comprises an image buffer (201) for storing the signal image point and a mask buffer (211, 217, 219) for storing the mask image address of the mask image point.

3. Analytical device according to claim 2,
wherein the image buffer (201) is designed to provide the signal image address of the signal image point.

4. Analytical device according to one of claims 1 to 3,
wherein the comparison means (103) is designed to establish on the basis of the arrangement of the signal image point with respect to the mask image point whether the signal image point is arranged inside or outside a mask range determined by the mask.

5. Analytical device according to one of claims 1 to 4, wherein the buffer or storage means (101) is designed to provide a further mask image address of a further mask image point, and
wherein the comparison means (103) is designed to compare the signal image address with the mask image address and with the further mask image address in order to determine the arrangement of the signal image point with respect to the mask image point and with respect to the further mask image point.

6. Analytical device according to claim 5,
wherein the signal image point, the mask image point and the further mask image point are arranged inside the same image row or the same image column, and
wherein the mask image point establishes a start and wherein the further mask image point establishes an end of a mask range arranged inside the image row or the image column.

7. Analytical device according to claim 5 or 6,
wherein the comparison means (103) is also designed to establish on the basis of the arrangement of the signal image point with respect to the mask image point and the further mask image point whether the signal image point is arranged inside or outside a tolerance range established by the mask image point and the further mask image point.

8. Analytical device according to one of claims 1 to 7, wherein the comparison means (103) is designed to establish that no mask violation is present if one or more of the following conditions are fulfilled:
mₛₜₐᵣₜ < yₛₜₐᵣₜ and m_{end} < yₛₜₐᵣₜ
or
mₛₜₐᵣₜ > y_{end} and m_{end} > y_{end}
or
mₛₜₐᵣₜ ≤ yₛₜₐᵣₜ and m_{end} ≥ y_{end},
in which mₛₜₐᵣₜ is a mask image address of a mask image point, in which m_{end} is a further mask image address of a further mask image point, in which yₛₜₐᵣₜ is a signal image address of a signal image point and in which y_{end} is a further signal image address of a further signal image point.

9. Analytical device according to one of claims 1 to 8, wherein the buffer or storage means (101) is designed to provide a plurality of pairs of mask image addresses, wherein one pair of mask image addresses comprises a mask image address and a further mask image address and establishes a mask range inside an image column or an image row.

10. Analytical device according to one of claims 1 to 9, which further comprises a detection means for detecting the signal waveform and a calculation means for calculating the signal image address from the detected signal waveform.

11. Analytical method for analysing a signal waveform using a mask, wherein the signal waveform can be represented graphically by a signal image and wherein the mask can be represented graphically by a mask image, with the method steps:
provision of a mask image address of a mask image point of the mask image;
provision of a signal image address of a signal image point of the signal image; and
comparison of the signal image address and the mask image address in order to determine an arrangement of the signal image point with respect to the mask image point,
**characterised in that**
a plurality of arbitrarily formed masks can be created over an entire image screen width by means of a plurality of mask buffers.

12. Analytical method according to claim 11, with the additional method steps:
provision of the signal image point in an image buffer; and
provision of the mask image address in a mask buffer.

13. Analytical method according to claim 12, with the additional method steps:
provision of the signal image address on the basis of the signal image point.

14. Analytical method according to one of claims 11 to 13, with the additional method steps:
establishment on the basis of the arrangement of the signal image point with respect to the mask image point whether the signal image point is arranged inside or outside a mask range established by the mask.

15. Analytical method according to one of claims 11 to 14, with the additional method steps:
provision of a further mask image address of a further mask image point; and
comparison of the signal image address with the mask image address and with the further mask image address in order to determine the arrangement of the signal image point with respect to the mask image point and with respect to the further mask image point.

16. Analytical method according to claim 15,
wherein the signal image point, the mask image point and the further mask image point are arranged inside the same image row or the same image column, and wherein the mask image point establishes a start and wherein the further mask image point establishes an end of a mask range arranged inside the image row or the image column.

17. Analytical method according to claim 15 or 16, with the additional method steps:
establishment on the basis of the arrangement of the signal image point with respect to the mask image point and the further mask image point whether the signal image point is arranged inside or outside a tolerance range established by the mask image point and by the further mask image point.

18. Analytical method according to one of claims 11 to 17, with the additional method steps:
provision of a further signal image address of a further signal image point; and
comparison of the mask image address with the signal image address and with the further signal image address in order to determine the arrangement of the signal image point and of the further signal image point with respect to the mask image point.

19. Analytical method according to one of claims 11 to 18, with the additional method steps:
establishment that no mask violation is present if one or more of the following conditions are fulfilled:
mₛₜₐᵣₜ < yₛₜₐᵣₜ and m_{end} < yₛₜₐᵣₜ
or
mₛₜₐᵣₜ > y_{end} and m_{end} > y_{end}
or
mₛₜₐᵣₜ ≤ yₛₜₐᵣₜ and m_{end} ≥ y_{end},
in which mₛₜₐᵣₜ is a mask image address of a mask image point, in which m_{end} is a further mask image address of a further mask image point, in which yₛₜₐᵣₜ is a signal image address of a signal image point and in which y_{end} is a further signal image address of a further signal image point.

20. Analytical method according to one of claims 11 to 19, with the additional method steps:
provision of a plurality of pairs of mask image addresses, wherein a pair of mask image addresses comprises a mask image address and a further mask image address and establishes a mask range inside an image column or an image row.

21. Analytical method according to one of claims 11 to 20, with:
detection of the signal waveform; and
calculation of the signal image address from the detected signal waveform.

22. Digital storage medium with electronically readable control signals which are able to cooperate with a programmable computer or digital signal processor so that the method according to one of claims 11 to 21 is implemented.

23. Computer programme product with programme code means stored on a machine-readable medium in order to be able to carry out all the steps according to one of claims 11 to 21 when the programme is implemented on a computer or a digital signal processor.

24. Computer programme with programme code means in order to be able to carry out all the steps according to one of claims 11 to 21 when the programme is implemented on a computer or a digital signal processor.

## Revendications

1. Dispositif d'analyse pour l'analyse de la variation d'un signal au moyen d'un masque, dans lequel la variation du signal peut être représentée graphiquement par une image du signal et le masque par une image du masque, comprenant :
un dispositif mémoire (101) pour la fourniture d'une adresse d'image du signal d'un point d'image du signal de l'image du signal et pour la fourniture d'une adresse d'image du masque d'un point d'image du masque de l'image du masque ; et
un système de comparaison (103) ;
dans lequel plusieurs masques de forme quelconque peuvent être réalisés sur toute une largeur d'écran au moyen de plusieurs mémoires de masque,
**caractérisé**
**en ce que** le système de comparaison (103) est configuré pour comparer l'adresse d'image du signal à l'adresse d'image du masque, afin de déterminer une disposition du point d'image du signal par rapport au point d'image du masque.

2. Dispositif d'analyse selon la revendication 1,
dans lequel le dispositif mémoire (101) comprend une mémoire d'image (201) pour la mise en mémoire du point d'image du signal et une mémoire de masque (211, 217, 219) pour la mise en mémoire de l'adresse d'image du masque du point d'image du masque.

3. Dispositif d'analyse selon la revendication 2,
dans lequel la mémoire d'image (201) est conçue pour fournir l'adresse d'image du signal du point d'image du signal.

4. Dispositif d'analyse selon l'une quelconque des revendications 1 à 3,
dans lequel le système de comparaison (103) est conçu pour établir, sur la base de la disposition du point d'image du signal par rapport au point d'image du masque, si le point d'image du signal est disposé à l'intérieur ou à l'extérieur d'une zone de masque prédéfinie par le masque.

5. Dispositif d'analyse selon l'une quelconque des revendications 1 à 4,
dans lequel le dispositif mémoire (101) est conçu pour fournir une autre adresse d'image du masque d'un autre point d'image du masque, et
dans lequel le système de comparaison (103) est conçu pour comparer l'adresse d'image du signal à l'adresse d'image du masque et à l'autre adresse d'image du masque, afin de déterminer la disposition du point d'image du signal par rapport au point d'image du masque et par rapport à l'autre point d'image du masque.

6. Dispositif d'analyse selon la revendication 5,
dans lequel le point d'image du signal, le point d'image du masque et l'autre point d'image du masque sont disposés à l'intérieur de la même ligne d'image ou de la même colonne d'image, et dans lequel le point d'image du masque définit un début et dans lequel l'autre point d'image du masque définit une fin d'une zone de masque disposée à l'intérieur de la ligne d'image ou de la colonne d'image.

7. Dispositif d'analyse selon la revendication 5 ou 6,
dans lequel le système de comparaison (103) est conçu en outre pour établir, sur la base de la disposition du point d'image du signal par rapport au point d'image du masque et de l'autre point d'image du masque, si le point d'image du signal est disposé à l'intérieur ou à l'extérieur d'une zone de tolérance définie par le point d'image du masque et l'autre point d'image du masque.

8. Dispositif d'analyse selon l'une quelconque des revendications 1 à 7,
dans lequel le système de comparaison (103) est conçu pour établir qu'aucune violation du masque n'est présente, au cas où une ou plusieurs des conditions suivantes serait/seraient remplie(s) :
mₛₜₐᵣₜ < yₛₜₐᵣₜ et m_{end} < yₛₜₐᵣₜ
ou
mₛₜₐᵣₜ > y_{end} et m_{end} > y_{end}
ou
mₛₜₐᵣₜ ≤ yₛₜₐᵣₜ et m_{end} ≥ y_{end},
où mₛₜₐᵣₜ est une adresse d'image du masque d'un point d'image du masque, où m_{end} est une autre adresse d'image du masque d'un autre point d'image du masque, où yₛₜₐᵣₜ est une adresse d'image du signal d'un point d'image du signal et où y_{end} est une autre adresse d'image du signal d'un autre point d'image du signal.

9. Dispositif d'analyse selon l'une quelconque des revendications 1 à 8,
dans lequel le dispositif mémoire (101) est conçu pour fournir une pluralité de paires d'adresses d'image du masque,
dans lequel une paire d'adresses d'image du masque comporte une adresse d'image du masque et une autre adresse d'image du masque et définit une zone de masque à l'intérieur d'une colonne d'image ou d'une ligne d'image.

10. Dispositif d'analyse selon l'une quelconque des revendications 1 à 9, qui comprend en outre un système de détection pour la détection de la variation du signal et un système de calcul pour le calcul de l'adresse d'image du signal à partir de la variation détectée du signal.

11. Procédé d'analyse pour l'analyse d'une variation du signal au moyen d'un masque, dans lequel la variation du signal peut être représentée graphiquement par une image du signal et le masque par une image du masque, qui comprend les étapes de procédé suivantes :
fournir une adresse d'image du masque d'un point d'image du masque de l'image du masque ;
fournir une adresse d'image du signal d'un point d'image du signal de l'image du signal ; et
comparer l'adresse d'image du signal et l'adresse d'image du masque, afin de déterminer une disposition du point d'image du signal par rapport au point d'image du masque,
**caractérisé**
**en ce que** plusieurs masques de forme quelconque sont réalisés sur toute une largeur d'écran au moyen de plusieurs mémoires de masque.

12. Procédé d'analyse selon la revendication 11, comprenant les étapes supplémentaires de procédé suivantes :
fournir le point d'image du signal dans une mémoire d'image ; et
fournir l'adresse d'image du masque dans une mémoire de masque.

13. Procédé d'analyse selon la revendication 12, comprenant les étapes supplémentaires de procédé suivantes :
fournir l'adresse d'image du signal sur la base du point d'image du signal.

14. Procédé d'analyse selon l'une quelconque des revendications 11 à 13, comprenant les étapes supplémentaires de procédé suivantes :
établir, sur la base de la disposition du point d'image du signal par rapport au point d'image du masque, si le point d'image du signal est disposé à l'intérieur ou à l'extérieur d'une zone de masque prédéfinie par le masque.

15. Procédé d'analyse selon l'une quelconque des revendications 11 à 14, comprenant les étapes supplémentaires de procédé suivantes :
fournir une autre adresse d'image du masque d'un autre point d'image du masque ; et
comparer l'adresse d'image du signal à l'adresse d'image du masque et à l'autre adresse d'image du masque, afin de déterminer la disposition du point d'image du signal par rapport au point d'image du masque et par rapport à l'autre point d'image du masque.

16. Procédé d'analyse selon la revendication 15,
dans lequel le point d'image du signal, le point d'image du masque et l'autre point d'image du masque sont disposés à l'intérieur de la même ligne d'image ou de la même colonne d'image, et dans lequel le point d'image du masque définit un début et dans lequel l'autre point d'image du masque définit une fin d'une zone de masque disposée à l'intérieur de la ligne d'image ou de la colonne d'image.

17. Procédé d'analyse selon la revendication 15 ou 16, comprenant les étapes supplémentaires de procédé suivantes :
établir, sur la base de la disposition du point d'image du signal par rapport au point d'image du masque et de l'autre point d'image du masque, si le point d'image du signal est disposé à l'intérieur ou à l'extérieur d'une zone de tolérance définie par le point d'image du masque et par l'autre point d'image du masque.

18. Procédé d'analyse selon l'une quelconque des revendications 11 à 17, comprenant les étapes supplémentaires de procédé suivantes :
fournir une autre adresse d'image du signal d'un autre point d'image du signal ; et
comparer l'adresse d'image du masque à l'adresse d'image du signal et à l'autre adresse d'image du signal, afin de déterminer la disposition du point d'image du signal et de l'autre point d'image du signal par rapport au point d'image du masque.

19. Procédé d'analyse selon l'une quelconque des revendications 11 à 18, comprenant les étapes supplémentaires de procédé suivantes :
établir qu'aucune violation du masque n'est présente, au cas où une ou plusieurs des conditions suivantes serait/seraient remplie(s) :
mₛₜₐᵣₜ yₛₜₐᵣₜ et m_{end} < yₛₜₐᵣₜ
ou
mₛₜₐᵣₜ > y_{end} et m_{end} > y_{end}
Ou
mₛₜₐᵣₜ ≤ yₛₜₐᵣₜ et m_{end} ≥ y_{end},
où mₛₜₐᵣₜ est une adresse d'image du masque d'un point d'image du masque, où m_{end} est une autre adresse d'image du masque d'un autre point d'image du masque, où yₛₜₐᵣₜ est une adresse d'image du signal d'un point d'image du signal et où y_{end} est une autre adresse d'image du signal d'un autre point d'image du signal.

20. Procédé d'analyse selon l'une quelconque des revendications 11 à 19, comprenant les étapes supplémentaires de procédé suivantes :
fournir une pluralité de paires d'adresses d'image du masque, dans lequel une paire d'adresses d'image du masque comporte une adresse d'image du masque et une autre adresse d'image du masque et définit une zone de masque à l'intérieur d'une colonne d'image ou d'une ligne d'image.

21. Procédé d'analyse selon l'une quelconque des revendications 11 à 20, comprenant les étapes suivantes :
détecter la variation du signal ; et
calculer l'adresse d'image du signal à partir de la variation détectée du signal.

22. Support de stockage numérique comprenant des signaux de commande lisibles électroniquement, qui peuvent coopérer avec un ordinateur programmable ou un processeur de signal numérique, de telle sorte que le procédé selon l'une quelconque des revendications 11 à 21 est mis en oeuvre.

23. Produit-programme informatique comprenant des moyens de code de programme mis en mémoire sur un support lisible par ordinateur, afin de pouvoir réaliser toutes les étapes selon l'une quelconque des revendications 11 à 21, lorsque le programme est exécuté sur un ordinateur ou un processeur de signal numérique.

24. Produit-programme informatique comprenant des moyens de code de programme, afin de pouvoir réaliser toutes les étapes selon l'une quelconque des revendications 11 à 21, lorsque le programme est exécuté sur un ordinateur ou un processeur de signal numérique.
